Europäisches Patentamt

European Patent Office

Office européen des brevets

(19)

(11) Numéro de publication: **0 239 432 B1**

(12) **FASCICULE DE BREVET EUROPEEN**

(45) Date de publication de fascicule du brevet:
26.06.91

(51) Int. Cl.⁵: **C23C 14/48**, C23C 14/28,
H01L 21/225

(21) Numéro de dépôt: 87400351.0

(22) Date de dépôt: 18.02.87

(54) **Procédé et dispositif de traitement d'un matériau par effet thermo-ionique en vue d'en modifier ses propriétés physicochimiques.**

(30) Priorité: 25.02.86 FR 8602568

(43) Date de publication de la demande:
30.09.87 Bulletin 87/40

(45) Mention de la délivrance du brevet:
26.06.91 Bulletin 91/26

(84) Etats contractants désignés:
DE FR GB

(56) Documents cités:
DE-A- 2 523 982      FR-A- 1 536 496
GB-A- 2 080 027      US-A- 3 551 213
US-A- 4 108 751      US-A- 4 474 827

PATENT ABSTRACTS OF JAPAN, vol. 7, no.
122 (C-168)[1267], 26 mai 1983; & JP-A-58 42
769

(73) Titulaire: **COMMISSARIAT A L'ENERGIE ATO-
MIQUE Etablissement de Caractère Scientifique Technique et Industriel
31/33, rue de la Fédération
F-75015 Paris(FR)**

(72) Inventeur: **Eloy, Jean François
505 chemin du Manival
F-38330 Saint-Ismier(FR)**

(74) Mandataire: **Mongrédien, André et al
c/o BREVATOME 25, rue de Ponthieu
F-75008 Paris(FR)**

## Description

La présente invention a pour objet un procédé et un dispositif permettant de traiter, superficiellement et en profondeur, un matériau par effet thermo-ionique en vue d'en modifier ses propriétés physico-chimiques.

Elle s'applique plus spécialement dans le domaine de la métallurgie pour modifier les propriétés mécaniques, en surface ou en profondeur, de métaux ou d'alliages (abaissement du coefficient de frottement, augmentation de la résistance aux chocs, l'usure, l'ablation, ...) ou pour modifier les propriétés chimiques de ces matériaux (résistance à la corrosion).

Toutefois, l'invention s'applique aussi dans le domaine de la micro-électronique pour modifier les propriétés électriques des semi-conducteurs et dans le domaine de l'optique intégrée pour modifier les indices de réfraction de certains matériaux.

En outre, l'invention s'applique aussi bien au traitement d'un matériau formant en partie la paroi externe d'une pièce, creuse ou pleine, qu'au traitement d'un matériau formant en partie la paroi interne d'une pièce creuse.

Il est actuellement connu d'utiliser l'implantation ionique de certaines espèces chimiques dans la couche superficielle de certains métaux afin d'en modifier leurs propriétés mécaniques superficielles.

En particulier, il est connu de réaliser un alliage superficiel en implantant des ions dans un matériau. Cette fabrication superficielle d'un alliage est notamment décrite dans un article de Thin Solid Films, 96 (1982), p.31-44, Metallurgical and protective coatings, de S. WEISSMANTEL et al., intitulé "Preparation and properties of hard i-C and i-BN coatings".

Malheureusement, l'implantation d'ions dans un matériau augmente considérablement les contraintes mécaniques de ce matériau diminuant notamment sa résistance à la corrosion.

Par ailleurs, il est connu du document US-A-4 398 966, publié le 16 août 1983, d'augmenter la résistance à la corrosion d'un acier en soumettant la surface de celui-ci à un rayonnement laser pulsé. L'impact laser à la surface de l'acier engendre un échauffement local élevé qui s'arrête en même temps que s'arrête l'impulsion laser ; ceci correspond à un phénomène de trempe superficielle ou recuit transitoire servant à bloquer la structure de l'acier obtenue à haute température.

Il est aussi connu d'utiliser un faisceau laser pulsé pour vaporiser un matériau, le matériau vaporisé pouvant être ensuite déposé sous forme de couches minces sur un support. Cette technique de dépôt en couches minces est notamment décrite dans un article de J.-DESSERRE et J.F. ELOY paru dans B.I.S.T. C.E.A. n°204, JUIN 1975, intitulé "Interaction d'un faisceau de lumière cohérente pulsée avec une cible complexe, application à l'élaboration de composés en couches minces".

La vaporisation d'un matériau en vue de son dépôt peut en particulier être réalisée en irradiant un bloc de ce matériau à travers un substrat optiquement transparent au rayonnement laser utilisé. Un tel procédé est notamment décrit dans le document EP-A-0 002 738.

Par ailleurs, il est connu de modifier les propriétés mécaniques superficielles d'un matériau en irradiant ce matériau à travers un substrat, par un rayonnement laser, le substrat étant optiquement transparent à ce rayonnement. Un tel procédé est notamment décrit dans le document US-A-4 401 477, publié le 30 août 1983.

Dans ce procédé, il est prévu de recouvrir la surface du matériau à traiter d'une couche absorbant les photons laser en vue d'accroître l'absorption du rayonnement laser par le matériau à traiter. Le laser utilisé est un laser de haute puissance et pulsé.

Le dépôt de cette couche absorbante de photons nécessite un état de surface particulier pour la pièce à traiter, ce qui augmente la durée du traitement du matériau. En outre, ce procédé de traitement nécessite l'usage d'une chambre de compression.

La présente invention a justement pour objet un procédé de traitement d'un matériau en vue d'en modifier ses propriétés physico-chimiques, et en particulier d'améliorer la résistance mécanique de ces matériaux, permettant de remédier aux différents inconvénients ci-dessus.

Ce procédé est basé sur une implantation d'ions dans laquelle les ions sont formés par vaporisation du matériau correspondant soumis à un rayonnement laser pulsé, ce rayonnement laser servant aussi au phénomène de trempe du matériau à traiter.

De façon plus précise, l'invention a pour objet un procédé de traitement d'un matériau par implantation ionique d'au moins un dopant, caractérisé en ce qu'il comprend les étapes suivantes :
- dépôt d'un film de dopant sur une surface de substrat,
- disposition du matériau en regard de ladite surface revêtue du film en laissant un espace entre le film et le matériau, espace que l'on ferme de manière étanche afin de former une cavité résonnante,
- irradiation du film, à travers le substrat, par un faisceau laser, collimaté et pulsé d'une longueur d'onde donnée afin de former des ions de dopant par vaporisation explosive du dopant, le substrat étant transparent à ladite longueur d'onde et, simultanément,
- création d'un champ électrique dans ledit espace pour accélérer les ions de dopant en vue de leur implantation thermo-ionique dans le matériau.

Le procédé selon l'invention permet, par rapport à celui décrit dans le document US-A-4 401 477 de supprimer le traitement préalable du matériau à traiter qui consistait essentiellement en un dépôt d'une couche absorbant les photons laser.

En effet, dans le procédé selon l'invention, dans l'espace compris entre le film de dopant et le matériau à traiter, la réflectivité globale du faisceau laser ainsi que des émissions lumineuses (X, UV,...), résultant de l'interaction du faisceau laser avec les ions créés, ne dépend que du film de dopant recouvrant l'une des surfaces opposées du substrat d'une part, et de sa tenue mécanique d'autre part ; la nature du film et sa tenue mécanique déterminent le temps pendant lequel ce film réfléchit le faisceau laser en direction du matériau à traiter, jusqu'à sa complète destruction. Ce temps reste court comparé à la durée de l'impulsion laser (de l'ordre de 10% de l'impulsion laser).

Le procédé de l'invention permet donc d'améliorer notablement le rendement énergétique de l'interaction laser-film par rapport à l'art antérieur.

Par ailleurs, ce procédé ne nécessite pas d'état de surface particulier de la surface du matériau à traiter.

Le procédé selon l'invention, grâce à l'utilisation d'un champ électrique simultanément à l'irradiation du film de dopant, permet une implantation d'ions dans le matériau à traiter s'accompagnant d'un effet thermique dans ce matériau, en surface et en profondeur. Cet effet thermique facilite l'implantation et permet ainsi d'éviter les effets néfastes de l'implantation.

Ce phénomène thermique résulte d'une onde de pression, très élevée, induite d'une part par la vaporisation explosive du matériau et, d'autre part, par la décharge produite entre le film de dopant et le matériau à traiter. Cette décharge est due au courant électronique induit par le champ électrique créé entre le matériau et le film de dopant, ces électrons provenant notamment de l'ionisation du dopant.

L'onde de pression induite pénètre transitoirement dans les couches superficielles du matériau, favorisant ainsi l'implantation, et dans les couches profondes améliorant ainsi les propriétés mécaniques de ces couches profondes.

En outre, le procédé de l'invention assure une trempe ultra-rapide du matériau, compte tenu de la durée courte du procédé (inférieure à 1μs).

De préférence, le rayonnement laser est un rayonnement électromagnétique dont la longueur d'onde va de 190 à 1100 nm. En effet, l'utilisation d'un tel rayonnement permet d'augmenter l'effet thermique accompagnant l'implantation ionique.

L'efficacité du procédé selon l'invention peut être avantageusement augmentée en irradiant le film de dopant perpendiculairement au plan de ce film.

En outre, il est avantageux de fermer de manière étanche l'espace compris entre le matériau à traiter et le film de dopant. En effet, ceci permet de former une cavité résonnante physiquement constituée par la surface du matériau à traiter, partiellement réfléchissante et par la surface du film de dopant en regard du matériau. Cette surface du film étant transitoirement réfléchissante pendant le temps précédant la destruction totale du film (vaporisation).

Selon un mode préféré de mise en oeuvre du procédé de l'invention, l'espace étanche est mis sous pression. La pression peut aller de $10^{-1}$ à $10^7$ Pa.

Cette mise sous pression est réalisée en particulier en introduisant un gaz ou un mélange de gaz sous pression, éventuellement ionisable, dans l'espace.

L'ionisation de ce gaz additionnel, due à une interaction avec le faisceau laser et/ou le champ électrique, permet d'augmenter le taux d'ionisation du milieu présent entre le matériau à traiter et le film de dopant et d'augmenter l'intensité de l'onde de pression ou de choc thermique. Ceci permet donc d'augmenter considérablement l'efficacité du procédé de l'invention.

Comme gaz, on peut utiliser des gaz inertes tels que des gaz rares (néon, argon, krypton), de l'azote. L'utilisation d'un gaz inerte est notamment nécessaire lorsque l'on désire éviter toute présence d'oxygène dans l'espace film dopant-matériau à traiter, cet oxygène risquant de réagir avec le matériau à traiter et de le dégrader.

On peut aussi utiliser des gaz actifs ionisables, Les ions formés à partir de ces gaz étant aptes à être implantés dans le matériau à traiter. En particulier, les ions issus de ces gaz actifs peuvent être les mêmes que ceux issus de la vaporisation du film de dopant. Par exemple, le film de dopant peut être un élément simple (bore, phosphore, silicium...) et le gaz additionnel un halogénure de cet élément ($BCl_3$, $SiCl_4$,...).

De façon générale, les ions à implanter pour modifier les propriétés d'un matériau Quelconque Sont des ions positifs. En conséquence, l'accélération de ces ions du film de dopant vers le matériau à traiter est réalisée en portant le substrat à un potentiel positif et le matériau au potentiel de la masse ou à un potentiel négatif.

Lorsque le substrat est conducteur, le potentiel positif lui est appliqué directement. En revanche, lorsque le substrat est un diélectrique, le potentiel positif lui est appliqué via une électrode accolée au substrat.

De façon avantageuse, on préchauffe le matériau à traiter afin d'augmenter la longueur de diffusion des ions implantés dans le matériau. Ce préchauffage est réalisé de préférence par une partie latérale du rayonnement laser, utilisé pour la vaporisation du film de dopant.

Le procédé selon l'invention décrit précédemment s'applique à tout type de matériau dont on veut modifier les propriétés physico-chimiques comme par exemple les matériaux semi-conducteurs, les métaux, les alliages de métaux ou les matériaux composites.

L'invention a aussi pour objet un dispositif permettant la mise en oeuvre du procédé de traitement selon l'invention.

Ce dispositif se caractérise en ce qu'il comprend :

- un substrat comportant une première et une seconde surfaces opposées, la première surface étant recouverte d'un film de dopant et étant apte à être disposée en regard du matériau tout en maintenant un espace entre le film et le matériau,
- au moins une bague rigide d'étanchéité servant à fermer hermétiquement ledit espace, cette bague étant réalisée en un matériau isolant électriquement,
- une source engendrant un faisceau laser, collimaté et pulsé, d'une longueur d'onde donnée, dirigée sur la seconde surface du substrat transparent à ladite largeur d'onde, ce faisceau laser étant apte à interagir avec le film de dopant, via le substrat, pour former des ions de dopant par vaporisation explosive dudit dopant, et
- des moyens électriques pour engendrer, simultanément à l'impulsion laser, un champ électrique dans ledit espace pour accélérer les ions de dopant en vue de leur implantation thermo-ionique dans le matériau.

Selon un mode préféré de réalisation du dispositif selon l'invention, un système optique est prévu pour subdiviser le faisceau laser en deux parties, une première partie périphérique servant à préchauffer le substrat et une seconde partie centrale servant à la vaporisation du dopant, le film de dopant ne recouvrant qu'une partie de la première face du substrat.

En particulier, ce système optique comprend deux miroirs sphériques annulaires, un miroir interne et un miroir externe, disposés coaxialement sur le faisceau engendré par la source, la face concave des deux miroirs étant dirigée vers le matériau, la face réfléchissante du miroir interne étant orientée vers la source et la face réfléchissante du miroir externe étant orientée vers le matériau.

Contrairement au dispositif décrit dans le document US-A-4 401 477, il n'est pas nécessaire d'utiliser dans l'invention une chambre de compression du fait que c'est l'explosion du film de dopant qui crée localement une surpression et consécutivement une onde de pression (due à la cavité résonnante réalisée par le substrat et la surface du matériau à traiter) ou de choc thermique localisée. Toutefois, la présence d'une telle chambre de compression améliore encore l'efficacité du procédé.

Afin de former, selon l'invention, une cavité résonnante entre le film de dopant et le matériau à traiter, le dispositif comprend avantageusement une bague rigide d'étanchéité servant à fermer hermétiquement ledit espace : cette bague est réalisée en un matériau isolant électriquement afin d'assurer un bon isolement électrique entre le matériau à traiter et le film de dopant.

Cette cavité permet notamment de stocker temporairement l'énergie photonique initiale introduite dans la cavité par le système optique d'injection latérale de la partie périphérique du faisceau laser ainsi que d'amplifier cette énergie photonique.

L'invention s'applique avantageusement au traitement d'un matériau formant au moins en partie la paroi interne d'une pièce creuse.

Dans ce cas, le dispositif de l'invention comprend un manchon dont la surface externe est recouverte du film de dopant, ce manchon formant le substrat étant apte à être placé à l'intérieur de la pièce à traiter, un réflecteur situé dans le manchon pour réfléchir le faiceau laser sur la surface interne du manchon, des moyens pour effectuer un mouvement relatif entre le faiceau laser réfléchi et la surface interne du manchon afin d'irradier toute ladite surface interne.

Selon un mode préféré de réalisation, les moyens servant à effectuer ce mouvement relatif comprennent une pièce conductrice creuse comportant à proximité de l'une de ses extrémités un coude logé dans le manchon, cette extrémité prenant appui sur la surface interne du manchon jouant le rôle d'électrode, le réflecteur solidaire de ladite pièce conductrice étant logé dans le coude, la pièce conductrice étant apte à tourner autour d'un axe longitudinal et à se déplacer parallèlement à cet axe.

D'autres caractéritiques et avantages de l'invention ressortiront mieux de la description qui va suivre, donnée à titre illustratif et non limitatif, en référence aux figures annexées, dans lesquelles :

- la figure 1 illustre schématiquement le procédé de traitement selon l'invention,
- la figure 2 représente, en coupe longitudinale, un dispositif de traitement conforme l'invention, selon une première variante,
- la figure 3 représente schématiquement le système optique servant à subdiviser en deux parties le faisceau laser conformément à l'invention, et

- la figure 4 représente, en coupe longitudinale, un dispositif de traitement conforme à l'invention, selon une seconde variante.

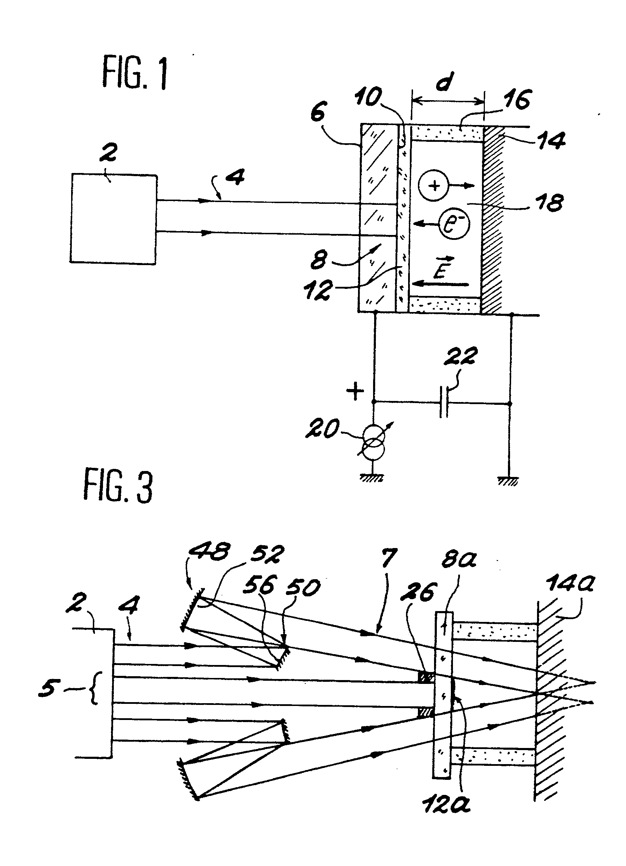

Sur la figure 1, on a représenté une source laser 2 émettant un faisceau laser 4 collimaté et pulsé dont on a représenté plusieurs rayons orientés parallèlement entre eux. Ce faisceau laser est en particulier un faisceau infrarouge de 1,06 $\mu$m de longueur d'onde. La durée de l'impulsion est comprise entre $10^{-9}$ et $10^{-6}$ s.

Ce faisceau laser 4 est dirigé sur une première surface 6 d'un substrat 8, transparent à la longueur d'onde du faisceau laser 4 utilisé. Pour un rayonnement laser infrarouge), le substrat peut être en verre, en plexiglas(R), en mylar(R), en oxyde de zinc, en oxyde d'étain et d'indium (ITO). La seconde surface 10 du substrat 8, opposée à la première, est recouverte d'un film 12 d'un matériau dopant. Le substrat 8 peut présenter une forme quelconque (plane ou courbe).

Le film 12 peut être déposé sur le substrat par évaporation sous vide. Son épaisseur est déterminée en fonction du flux du faisceau laser 4, de la durée d'une impulsion laser, ainsi que du pouvoir réfléchissant de ce film 12.

Ce film 12 peut être constitué d'un ou plusieurs éléments simples, tels que le bore, l'aluminium, le molybdène, le chrome, etc... ou bien d'un composé d'un élément simple tel qu'un oxyde ou un nitrure.

Ce film de dopant 12 est disposé en regard du matériau 14 à traiter. Ce matériau 14 est en particulier formé d'un métal tel que l'acier 316 ou d'un alliage métallique tel que les aciers rapides, les alliages d'aluminium (TiAl, AlLi), les alliages d'uranium, ou matériaux composites à base de fibres de carbone.

Une bague intercalaire 16 en matériau isolant électriquement, permet de maintenir un espace d suffisant entre le film de dopant 12 et le matériau à traiter 14 pour permettre l'accélération des particules ionisées lors de l'interaction laser. En outre, cette bague 16, réalisée par exemple en fibres de verre et d'amiante, permet de délimiter avec le film de dopant 12 et le matériau à traiter 14 une chambre étanche 18 dans laquelle une onde de choc peut exister pendant la durée d'une impulsion laser.

Cette chambre 18, jouant le rôle de cavité résonnante, peut être mise sous pression et contenir un gaz inerte tel qu'un gaz rare ou de l'azote ou bien un gaz actif ionisable apte à former des ions qui peuvent être implantés dans le matériau à traiter.

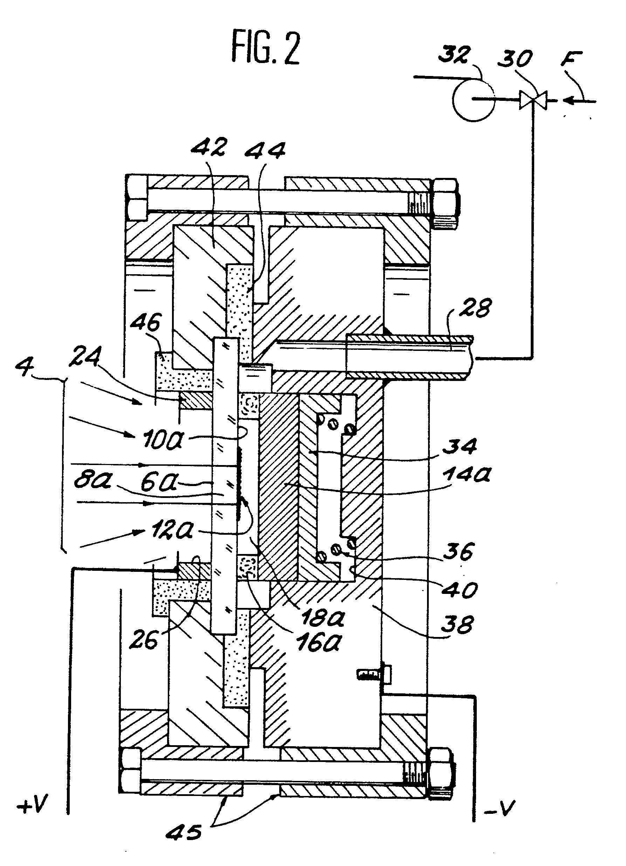

Le substrat qui peut être isolant (figure 2) ou conducteur (figure 1) est porté à un potentiel positif délivré par une source de tension 20 continue.

Parallèlement, le matériau 14 est porté à la masse ou à un potentiel négatif. Cette différence de potentiel permet de créer dans la chambre étanche 18 ou cavité un champ électrique $\vec{E}$ servant à accélérer les ions de dopant positifs formés.

Afin d'assurer une réserve énergétique et le maintien des polarités respectives du substrat 8 et du matériau à traiter 14, une capacité 22 à faible impédance, connectée en parallèle entre le substrat 8 et le matériau à traiter 14 peut être prévue. L'une des plaques du condensateur 22 est reliée à la source de tension 20 et l'autre à la masse ou à un potentiel négatif.

Le faisceau de lumière parallèle 4 orienté perpendiculairement au film de dopant 12 permet en interagissant avec le film de dopant 12, via le substrat 8, de vaporiser de façon explosive ce film 12. La vapeur de dopant engendrée dans la chambre 18 est ionisée grâce à la présence du champ électrique $\vec{E}$ et de l'interaction du faisceau laser 4 avec la vapeur après disparition du film notamment.

Les ions formés sont ensuite accélérés grâce au champ électrique $\vec{E}$ de valeur élevée (supérieure à 1 kV/cm).

Afin que les ions formés soient suffisamment accélérés pour être implantés dans le matériau à traiter 14, l'espace d séparant le film de dopant 12 et le matériau à traiter 14 doit être suffisamment important ; cet espace d peut aller de 0,01 à 1 cm.

L'onde de pression ou onde thermique induite par la vaporisation explosive du film de dopant 12 et la décharge produite dans la chambre de compression 18 sous l'effet des électrons induits par le champ électrique $\vec{E}$ assurent l'implantation thermoionique, dans le matériau 14, des ions de dopant et le cas échéant des ions du gaz contenu dans la chambre.

La durée relativement courte de l'irradiation laser (inférieure à $10^{-6}$s) crée une trempe ultrarapide du matériau implanté 14 du fait d'un puits thermique présenté par le matériau 14 à traiter luimême. En effet, l'onde de refroidissement subséquente, à l'interruption brusque de l'irradiation laser, remonte du coeur du matériau 14 vers sa surface.

Sur la figure 2, on a représenté en coupe un dispositif permettant le traitement d'une plaque plane métallique 14a. Cette plaque métallique 14a est disposée en regard du substrat ayant aussi la forme d'une plaque plane, transparente au faisceau laser 4. Ce substrat 8a est isolant et sa face "interne" 10a n'est recouverte que partiellement d'un film de dopant 12a. L'autre face 6a est équipée d'une électrode 24 présentant une ouverture 26 dans sa partie centrale afin de permettre le passage du faisceau laser 4 à travers ladite électrode. Cette électrode 24 présente par exemple une forme annulaire.

L'espace d défini entre la surface interne 10a du substrat 8a en regard de la plaque 14a à traiter et la plaque 14a elle-même est fermé hermétiquement par une bague annulaire 16a dite de pression, isolante électriquement. Sur cette bague 16a est montée une conduite de gaz 28 reliée, via une vanne deux voies 30, à une pompe 32 permettant de purger la chambre 18a en cas de besoin. En particulier, le traitement selon l'invention d'un métal ou d'un alliage se fait en l'absence d'oxygène afin d'empêcher l'oxydation de ce métal.

Par ailleurs, la vanne 30 permet l'introduction, comme représenté par la flèche F, d'un gaz inerte ou actif à l'intérieur de la chambre 18a.

Dans le cas d'implantation d'ions de bore dans une plaque 14a en aluminium, le gaz utilisé peut être du chlorure de bore qui, sous l'impact du faisceau laser 4 et du champ électrique s'ionise et participe à l'implantation d'ions de bore dans la plaque 14a.

Dans le mode de réalisation représenté sur la figure 2, la plaque à traiter 14a est appliquée sur la bague d'étanchéité 16a au moyen d'une contre-plaque 34, notamment conductrice, sollicitée en compression par un ressort 36. Cette mise sous contrainte de la chambre 18a justifie son nom de chambre de compression.

Le ressort 36 est solidaire d'une pièce métallique 38 comportant un évidement 40 dans lequel est logée la plaque à traiter 14a et la contre-plaque 34. La pièce conductrice 38 sur laquelle est appliqué un potentiel négatif -V ou le potentiel de la masse (figure 1) comporte une partie en contact avec la plaque métallique à traiter 14a.

Le substrat isolant 8a est monté sur une plaque support 42 qui peut être maintenue en regard de la pièce 38 par un système à brides 45.

Des joints 44, intercalés entre les pièces 38 et 42 assurent l'étanchéité de la chambre 18a.

En outre, un joint annulaire 46 isolant électriquement, entourant l'électrode 24 sur laquelle est appliqué un potentiel positif +V, est prévu afin d'éviter tout court-circuit entre le substrat 8a et la plaque métallique à traiter 14a.

Le système mécanique de mise sous contrainte ci-dessus permet de supporter l'onde de choc, due à l'interaction laser avec le film dopant et simultanément au champ électrique, créée dans la chambre de compression.

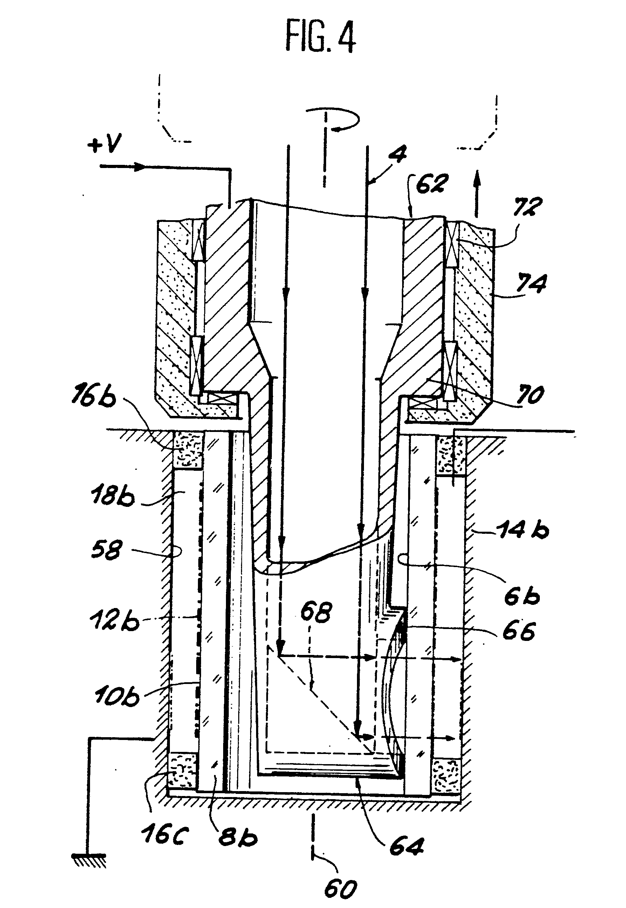

Afin d'augmenter la longueur de diffusion des ions de dopant et le cas échéant des ions du gaz contenu dans la chambre 18, dans le matériau à traiter, on effectue un préchauffage de celui-ci. Ce préchauffage peut être réalisé, comme représenté sur la figure 3, par subdivision du faisceau laser collimaté 4, engendré par la source 2, en deux parties, une partie centrale 5 et une partie latérale 7 ou périphérique. La partie centrale 5 sert à l'irradiation du film de dopant 12a pour permettre sa vaporisation et la partie latérale 7 sert au préchauffage de la plaque 14a à traiter.

Le fait que l'électrode annulaire 26 et le film de dopant 12a ne recouvrent que partiellement les surfaces correspondantes du substrat 8a, permet à la partie latérale 7 du faisceau laser, via le substrat 8a, de n'interagir qu'avec la plaque de matériau 14a à traiter.

Le système optique servant à la subdivision du faisceau laser 4 en deux parties est du type Cassegrain inversé. Il a notamment été décrit dans le brevet US-4 330 208 délivré le 18 mai 1982. Ce système se compose de deux miroirs sphériques annulaires 48 et 50. Ces deux miroirs sont disposés coaxialement sur le faiceau laser 4. Le miroir 48 est appelé miroir externe et est concave et le miroir 50 est appelé miroir interne et est convexe.

La face réfléchissante 56 du miroir interne 50 est orientée vers la source laser 2 et la face réfléchissante 52 du miroir externe 48 orientée vers la plaque 14a à traiter.

La forme annulaire des miroirs 48 et 50 permet le transfert direct, sans réflexion, de la partie centrale 5 du faisceau laser.

Les rayons de courbure et la distance focale des miroirs sont adaptés d'une part à la dimension du faiceau laser et d'autre part, à la dimension de l'électrode conductrice 26 ainsi qu'à la dimension de la surface de la plaque 14a à traiter. Ces éléments dimensionnels sont déterminés de façon que la partie latérale 7 du faisceau laser soit focalisée à l'intérieur du matériau à traiter. Typiquement, la distance focale du système optique est de 400 mm, le rayon de courbure du miroir interne 50 est de 900 mm et le rayon de courbure du miroir externe 48 est de 600 mm.

Le dispositif optique ci-dessus permet de bombarder préventivement la surface du matériau à traiter, en prélevant la partie périphérique du faisceau laser, souvent la moins intense, et de focaliser cette partie périphérique sur le même axe que la partie 5 non déviée et collimatée, la plus intense.

Cette partie centrale 5 produit la vaporisation explosive du film de dopant avec un léger temps de retard par rapport à la pré-irradiation par la partie périphérique 7 du faisceau laser. Ainsi, le matériau à traiter subit une sensibilisation de sa surface et une phase de pré-absorption produisant une première onde thermique initialisant le phénomène d'onde de choc ou de pression.

Sur la figure 4, on a représenté un dispositif selon l'invention pour traiter un matériau formant au moins en partie la paroi interne d'une pièce creuse, notamment cylindrique.

Sur cette figure, la pièce creuse porte la référence 14b et la paroi interne à traiter la référence 58. La référence 60 représente l'axe central longitudinal de symétrie de l'évidement de la pièce à traiter.

A l'intérieur de la pièce à traiter, on dispose un manchon 8b de forme cylindrique jouant le rôle du substrat, transparent au faisceau laser 4 collimaté utilisé. L'axe longitudinal du manchon coïncide avec l'axe 60. La surface externe 10b de ce manchon est recouverte du film de dopant 12b. Le film de dopant 12b est ainsi situé en regard de la paroi interne 58 de la pièce creuse à traiter, et à une certaine distance de ladite paroi.

Ce dispositif de traitement comprend de plus une pièce conductrice creuse 62 comportant au voisinage de l'une de ses extrémités 66, un coude 64. Ce coude est logé dans le manchon 8b. L'extrémité 66 de la pièce 62 prend appui sur la surface interne 6b du manchon 8b. Cette extrémité 66 joue le rôle d'une électrode servant à porter le manchon 8b à un potentiel positif.

La pièce 62 conductrice est isolée de la masse ou du potentiel négatif appliqué à la pièce à traiter.

Un réflecteur optique 68 est logé dans le coude 64 de la pièce conductrice 62 et est solidaire de cette pièce. Ce réflecteur 68 peut être un miroir disposé obliquement dans le coude ou un prisme à réflexion totale ; la face réfléchissante du réflecteur forme un angle de 45° par rapport à l'axe 60 et est orientée vers l'extrémité 66. Le faisceau laser réfléchi par le réflecteur 68 est ainsi envoyé selon une direction radiale perpendiculaire à l'axe 60.

Ce réflecteur 68 doit pouvoir réfléchir totalement la longueur d'onde du faisceau laser 4 envoyé à l'intérieur de la pièce 62, parallèlement à l'axe longitudinal 60. Ce réflecteur 68 peut être traité multicouche afin de supporter les hauts flux laser utilisés pour le traitement de la surface interne de la pièce 14b.

Afin de traiter totalement la paroi interne 58 de la pièce creuse 14b, la pièce conductrice 62 peut se déplacer longitudinalement selon l'axe 60, comme le montrent les flèches. De même, cette pièce 62 doit pouvoir tourner autour de cet axe 60.

A cet effet, la pièce 62 comporte une partie évasée 70 située à l'extérieur du manchon 8b reposant sur des galets 72 ou roulements logés à l'intérieur d'une pièce 74 isolante cylindrique dont l'axe longitudinal coïncide avec l'axe 60.

La mise en rotation et/ou en translation de la pièce 62 est assurée de façon connue, notamment à l'aide de moteurs pas à pas (non représentés). Un système de repérage (non représenté) peut éventuellement être prévu pour repérer la position de la pièce 62 par rapport à la surface 58 à traiter.

Afin que l'espace annulaire défini entre le manchon 8b et la paroi interne 58 de la pièce à traiter constitue une chambre de compression 18b étanche, deux bagues annulaires respectivement 16b et 16c, isolantes électriquement peuvent être montées aux deux extrémités du manchon 8b. Comme précédemment, la chambre 18b ainsi définie peut être mise sous pression et/ou remplie d'un gaz inerte ou actif.

L'irradiation de tout le film de dopant 12b, via le manchon 8b, est effectuée par des tirs laser successifs et ce sans démontage, ni remplacement des éléments constitutifs du dispositif.

Les procédés et dispositifs de l'invention ont permis de traiter une pièce en acier en vue d'en diminuer son coefficient de frottement, ceci a été réalisé en implantant de l'aluminium ou du molybdène superficiellement dans l'acier.

Pour cela, on a utilisé une source laser émettant un faisceau de 1,06 $\mu$m de longueur d'onde, d'une puissance de 200MW/cm$^2$ et dont la durée des impulsions était de $3.10^{-8}$s. Le substrat utilisé était de l'Al. L'espace d séparant la couche de dopant et la surface du matériau à traiter était de 0,05cm. En outre, l'épaisseur du film de dopant était de 0,08$\mu$m et le champ électrique de $2.10^4$ V/cm. La chambre de compression était remplie de N$_2$ sous une pression de 1 bar.

Dans les mêmes conditions, on a effectué une implantation thermo-ionique de chrome dans un alliage en TiAl afin d'augmenter la résistance à l'ablation de cet alliage.

**Revendications**

1. Procédé de traitement d'un matériau en vue d'en modifier ses propriétés physico-chimiques par implantation ionique d'au moins un dopant, caractérisé en ce qu'il comprend les étapes suivantes :
   - dépôt d'un film de dopant (12, 12a, 12b) sur une surface (10, 10a, 10b) d'un substrat (8, 8a, 8b),
   - disposition du matériau (14, 14a, 14b) en regard de ladite surface revêtue du film en laissant un espace (18, 18a, 18b) entre le film et le matériau, espace que l'on ferme de manière étanche afin de former une cavité résonnante,
   - irradiation du film, à travers le substrat (8, 8a, 8b), par un faisceau laser (4), collimaté et pulsé, d'une longueur d'onde donnée afin de former des ions de dopant par vaporisation explosive du dopant, le substrat étant transparent à ladite longueur d'onde et, simultanément,
   - création d'un champ électrique ($\vec{E}$) dans ledit espace (18, 18a, 18b) pour accélérer les ions de dopant en vue de leur implantation thermo-ionique dans le matériau.

2. Procédé de traitement selon la revendication 1, caractérisé en ce que le faisceau laser (4) est un rayonnement infrarouge, visible ou ultraviolet.

3. Procédé de traitement selon la revendication 1 ou 2, caractérisé en ce que l'on irradie le film (12, 12a, 12b) perpendiculairement au plan du film.

4. Procédé de traitement selon l'une quelconque des revendications 1 à 3, caractérisé en ce que l'on remplit ledit espace (18, 18a, 18b) d'un gaz capable de former des ions aptes à être implantés dans le matériau.

5. Procédé de traitement selon l'une quelconque des revendications 1 à 3, caractérisé en ce que l'on remplit ledit espace (18, 18a, 18b) d'un gaz inerte.

6. Procédé de traitement selon l'une quelconque des revendications 1 à 5, caractérisé en ce que l'on met ledit espace sous pression.

7. Procédé de traitement selon l'une quelconque des revendications 1 à 6, caractérisé en ce que l'on crée le champ électrique ($\vec{E}$) en portant le substrat (8, 8a, 8b) à un potentiel positif et le matériau (14, 14a, 14b) au potentiel de la masse ou à un potentiel négatif.

8. Procédé de traitement selon l'une quelconque des revendications 1 à 7, caractérisé en ce que l'on préchauffe le matériau (14, 14a, 14b) pour favoriser l'implantation ionique.

9. Procédé de traitement selon la revendication 8, caractérisé en ce que le préchauffage est réalisé par une partie latérale (7) du faisceau laser.

10. Dispositif pour traiter un matériau en vue d'en modifier ses propriétés physico-chimiques par implantation ionique d'au moins un dopant, caractérisé en ce qu'il comprend :
   - un substrat (8, 8a, 8b) comportant une première (10, 10a, 10b) et une seconde (6, 6a, 6b) surfaces opposées, la première surface étant recouverte d'un film de dopant (12, 12a, 12b) et étant apte à être disposée en regard du matériau (14, 14a, 14b) tout en maintenant un espace (18, 18a, 18b) entre le film et le matériau,
   - au moins une bague rigide (16, 16a, 16b, 16c) d'étanchéité servant à fermer hermétiquement ledit espace (18, 18a, 18b), cette bague étant réalisée en un matériau isolant électriquement,
   - une source (2) engendrant un faisceau laser (4), collimaté et pulsé, d'une longueur d'onde donnée, dirigé sur la seconde surface (6, 6a, 6b) du substrat transparent à ladite longueur d'onde, ce faisceau laser (4) étant apte à interagir avec le film de dopant, via le substrat, pour former des ions de dopant par vaporisation explosive dudit dopant, et
   - des moyens électriques (20, 22) pour engendrer, simultanément à l'impulsion laser, un champ électrique ($\vec{E}$) dans ledit espace pour accélérer les ions de dopant en vue de leur implantation thermo-ionique dans le matériau.

11. Dispositif selon la revendication 10, caractérisé en ce qu'il comprend des moyens (28, 30) d'amenée d'un gaz sous pression dans ledit espace (18, 18a, 18b).

12. Dispositif selon la revendication 10 ou 11, caractérisé en ce que les moyens électriques comportent un condensateur (22) connecté entre le substrat (8) et le matériau (14), le substrat étant porté à un potentiel positif et le matériau au potentiel de la masse ou à un potentiel négatif.

13. Dispositif selon l'une quelconque des revendications 10 à 12, caractérisé en ce que le substrat (8a, 8b) étant un diélectrique, une électrode (26, 64) est prévue sur la seconde surface du substrat (6a, 6b), cette électrode étant pourvue d'une ouverture (26) afin de permettre le passage du faisceau laser (4) à travers ladite électrode.

14. Dispositif selon l'une quelconque des revendications 10 à 13, caractérisé en ce qu'un système optique (48, 50) est prévu pour subdiviser le faisceau laser en deux parties, une première partie périphérique (7) servant à préchauffer le substrat et une seconde partie centrale (5) servant à la vaporisation du dopant, le film de dopant ne recouvrant qu'une partie de la première surface du substrat.

15. Dispositif selon la revendication 14, caractérisé en ce que le système optique comprend deux miroirs sphériques annulaires, un miroir interne (50) et un miroir externe (48), disposés coaxialement sur le faisceau laser (4) engendré par la source (2), la face concave (52, 54) des deux miroirs étant dirigée vers le matériau, la face (56) réfléchissante du miroir interne (4) étant orientée vers la source (2) et la face réfléchissante (52) du miroir externe (48) étant orientée vers le matériau.

16. Dispositif selon l'une quelconque des revendications 10 à 15 pour traiter un matériau formant au moins en partie la paroi interne (58) d'une pièce creuse (14b), caractérisé en ce qu'il comprend un manchon (8b) dont la surface externe (10b) est recouverte du film de dopant (12b), ce manchon (8b) formant le substat étant apte à être placé à l'intérieur de la pièce à traiter, un réflecteur (68) situé dans le manchon pour réfléchir le faisceau laser (4) sur la surface interne (66) du manchon (8b), des moyens (62, 68, 66) pour effectuer un mouvement relatif entre le faisceau laser (4) réfléchi et la surface interne (6b) du manchon afin d'irradier toute ladite surface interne.

17. Dispositif selon la revendication 16, caractérisé en ce que les moyens pour effectuer un mouvement relatif comprennent une pièce conductrice creuse (62) comportant à proximité de l'une de ses extrémités (66) un coude (64) logé dans le manchon, cette extrémité (66) prenant appui sur la surface interne (6b) du manchon jouant le rôle d'électrode, le réflecteur (68) solidaire de ladite pièce conductrice (62) étant logé dans le coude (64), la pièce conductrice étant apte à tourner autour d'un axe longitudinal (60) et à se déplacer parallèlement à cet axe.

**Claims**

1. Process for treating a material with a view to modifying its physicochemical properties by ion implantation of at least one dopant, characterized in that it comprises the following stages:
   - deposition of a dopant film (12, 12a, 12b) on a surface (10, 10a, 10b) of a substrate (8, 8a, 8b), positioning of the material (14, 14a, 14b) facing said film-coated surface, whilst leaving a space (18, 18a, 18b) between the film and the material, said space being tightly sealed to form a resonant cavity, irradiation of the film through the substrate (8, 8a, 8b) by a pulsed, collimated laser beam (4) having a given wavelength in order to form dopant ions by explosive vaporization of the dopant, the substrate being transparent to said wavelength and, simultaneously, producing an electric field ( $\vec{E}$ ) in said space (18, 18a, 18b) for accelerating the dopant ions with a view to their thermoionic implantation in the material.

2. Treatment process according to claim 1, characterized in that the laser beam (4) is an infrared, visible or ultraviolet radiation.

3. Treatment process according to claims 1 or 2, characterized in that the film (12, 12a, 12b) is irradiated perpendicular to its plane.

4. Treatment process according to any one of the claims 1 to 3, characterized in that the space (18, 18a, 18b) is filled with a gas able to form ions which can be implanted in the material.

5. Treatment process according to any one of the claims 1 to 3, characterized in that the space (18, 18a, 18b) is filled with an inert gas.

6. Treatment process according to any one of the claims 1 to 5, characterized in that the space is placed under pressure.

7. Treatment process according to any one of the claims 1 to 6, characterized in that the electric field ( $\vec{E}$ ) is produced by raising the substrate (8, 8a, 8b) to a positive potential and the material (14, 14a, 14b) to earth or negative potential.

8. Treatment process according to any one of the claims 1 to 7, characterized in that the material (14, 14a, 14b) is preheated in order to aid ion implantation.

9. Treatment process according to claim 8, characterized in that preheating is carried out by a lateral part (7) of the laser beam.

10. Apparatus for treating a material with a view to modifying its physicochemical properties by the ion implantation of at least one dopant, characterized in that it comprises:
    - a substrate (8, 8a, 8b) having first (10, 10a, 10b) and second (6, 6a, 6b) opposite surfaces, the first surface being covered with a dopant film (12, 12a, 12b) and can be positioned facing the material (14, 14a, 14b), whilst maintaining a space (18, 18a, 18b) between the film and the material,
    - at least one rigid sealing ring (16, 16a, 16b, 16c) used for hermetically sealing the said space (18, 18a, 18b), said ring being made from an electrically insulating material,
    - a source (2) producing a collimated, pulsed laser beam (4) with a given wavelength, directed onto the second surface (6, 6a, 6b) of the substrate which is transparent to said wavelength, the laser beam (4) being able to interact with the dopant film for forming dopant ions by explosive vaporization of said dopant and

- electrical means (20, 22) for producing, simultaneously with the laser pulse, an electric field ( $\vec{E}$ ) in said space in order to accelerate the dopant ions with a view to their thermoionic implantation in the material.

11. Apparatus according to claim 10, characterized in that it comprises means (28, 30) for supplying gas under pressure into said space (18, 18a, 18b).

12. Apparatus according to claims 10 or 11, characterized in that the electrical means comprise a capacitor (22) connected between the substrate (8) and the material (14), the substrate being raised to a positive potential and the material to earth or a negative potential.

13. Apparatus according to any one of the claims 10 to 12, characterized in that with the substrate (8a, 8b) being a dielectric, an electrode (26, 64) is provided on the second surface of the substrate (6a, 6b), said electrode being provided with an opening (26) in order to permit the passage of the laser beam (4) through said electrode.

14. Apparatus according to any one of the claims 10 to 13, characterized in that an optical system (48, 50) is provided for subdividing the laser beam into two parts, a first peripheral part (7) being used for preheating the substrate and a second central part (5) for vaporizing the dopant, the dopant film only covering a portion of the first surface of the substrate.

15. Apparatus according to claim 14, characterized in that the optical system comprises two annular spherical mirrors, an inner mirror (50) and an outer mirror (48) arranged coaxially on the laser beam (4) produced by the source (2), the concave face (52, 54) of the two mirrors being directed towards the material, the reflecting face (56) of the inner mirror (4) being oriented towards the source (2) and the reflecting face (52) of the outer mirror (48) towards the material.

16. Apparatus according to any one of the claims 10 to 15, for treating a material forming at least partly the inner wall (58) of a hollow member (14b), characterized in that it comprises a sleeve (8b), whose outer surface (10b) is covered with the dopant film (12b), said sleeve (8b) forming the substrate being positionable within the part to be treated, a reflector (68) located in the sleeve for reflecting the laser beam (4) on the inner surface (6b) of the sleeve (8b), means (62, 68, 66) for effecting a relative movement between the reflected laser beam (4) and the inner surface (6b) of the sleeve in order to irradiate all the inner surface.

17. Apparatus according to claim 16, characterized in that the means for effecting a relative movement comprise a hollow conductive part (62) having in the vicinity of one of its ends (66) a bend (64) located in the sleeve, said end (66) bearing on the inner surface (6b) of the sleeve serving as an electrode, the reflector (68) integral with said conductive part (62) being located in the bend (64), whereby the conductive part is able to rotate about a longitudinal axis (60) and move parallel thereto.

**Ansprüche**

1. Verfahren zum Behandeln eines Materials zur Modifizierung seiner physikalisch-chemischen Eigenschaften durch Implantation von Ionen mindestens eines Dotierungsmittels, dadurch gekennzeichnet, daß es die folgenden Stufen umfaßt:

- Abscheidung eines Films aus dem Dotierungsmittel (12,12a, 12b) auf einer Oberfläche (10,10a,10b) eines Substrats (8,8a,8b),
- Anordnung des Materials (14,14a,14b) gegenüber der von dem Film bedeckten Oberfläche in der Weise, daß ein Zwischenraum (18,18a,18b) zwischen dem Film und dem Material vorliegt, der dicht verschlossen wird unter Bildung eines Resonanzhohlraums,
- Bestrahlung des Films durch das Substrat (8,8a,8b) hindurch mit einem kollimierten und pulsierenden Laserstrahlbündel (4) einer gegebenen Wellenlänge, so daß durch explosive Verdampfung des Dotierungsmittels Dotierungsmittelionen gebildet werden, wobei das Substrat für diese Wellenlänge transparent ist, und
- gleichzeitige Erzeugung eines elektrischen Feldes ( $\vec{E}$ ) in dem Zwischenraum (18,18a,18b) zur Beschleunigung der Dotierungsmittelionen für ihre thermoionische Implantation in das Material.

2. Verfahren nach Anspruch 1, dadurch gekennzeichnet, daß das Laserstrahlbündel (4) eine infrarote, sichtbare oder ultraviolette Strahlung ist.

3. Verfahren nach Anspruch 1 oder 2, dadurch gekennzeichnet, daß man den Film (12,12a,12b) senkrecht zur Ebene des Films bestrahlt.

4. Verfahren nach einem der Ansprüche 1 bis 3, dadurch gekennzeichnet, daß man den Zwischenraum (18,18a,18b) mit einem Gas füllt, das Ionen bilden kann, die in das Material implantiert werden können.

5. Verfahren nach einem der Ansprüche 1 bis 3, dadurch gekennzeichnet, daß man den Zwischenraum (18,18a,18b) mit einem inerten Gas füllt.

6. Verfahren nach einem der Ansprüche 1 bis 5, dadurch gekennzeichnet, daß man den Zwischenraum unter Druck setzt.

7. Verfahren nach einem der Ansprüche 1 bis 6, dadurch gekennzeichnet, daß man das elektrische Feld ($\vec{E}$) erzeugt, indem man das Substrat (8,8a,8b) auf ein positives Potential bringt und das Material (14,14a,14b) auf das Masse-Potential oder ein negatives Potential bringt.

8. Verfahren nach einem der Ansprüche 1 bis 7, dadurch gekennzeichnet, daß man das Material (14,14a,14b) vorerwärmt, um die Ionenimplantation zu fördern.

9. Verfahren nach Anspruch 8, dadurch gekennzeichnet, daß man das Vorerwärmen durchführt mit einem Seitenabschnitt (7) des Laserstrahlbündels.

10. Vorrichtung zum Behandeln eines Material zur Modifizierung seiner physikalisch-chemischen Eigenschaften durch Implantation von Ionen mindestens eines Dotierungsmittels, dadurch gekennzeichnet, daß sie umfaßt:
 - ein Substrat (8,8a,8b), das eine erste Oberfläche (10,10a, 10b) und eine gegenüberliegende zweite Oberfläche (6,6a,6b) aufweist, wobei die erste Oberfläche von einem Film aus dem Dotierungsmittel (12,12a,12b) bedeckt ist und gegenüber dem Material (14,14a,14b) so angeordnet sein kann, daß ein Zwischenraum (18,18a,18b) zwischen dem Film und dem Material vorliegt,
 - mindestens einen starren Abdichtungsring (16,16a,16b,16c), der dazu dient, den Zwischenraum (18,18a,18b) hermetisch zu verschließen, und der aus einem elektrisch isolierenden Material besteht,
 - eine Quelle (2) für die Bildung eines kollimierten und pulsierenden Laserstrahlbündels einer gegebenen Wellenlänge, das auf die zweite Oberfläche (6,6a,6b) des für diese Wellenlänge transparenten Substrats gerichtet ist und das in der Lage ist, mit dem Dotierungsmittel-Film durch das Substrat hindurch in Wechselwirkung zu treten zur Erzeugung von Dotierungsmittel-Ionen durch explosive Verdampfung des Dotierungsmittels, und
 - elektrische Einrichtungen (20,22) zur Erzeugung eines elektrischen Feldes ($\vec{E}$) in dem Zwischenraum, gleichzeitig mit dem Impulslaser, um die Dotierungsmittel-Ionen zu beschleunigen zu ihrer thermoionischen Implantation in das Material.

11. Vorrichtung nach Anspruch 10, dadurch gekennzeichnet, daß sie Einrichtungen (28,30) zur Einführung eines Gases unter Druck in den Zwischenraum (18,18a,18b) aufweist.

12. Vorrichtung nach Anspruch 10 oder 11, dadurch gekennzeichnet, daß die elektrischen Einrichtungen umfassen einen Kondensator (22), der zwischen dem Substrat (8) und dem Material (14) angeordnet ist, wobei das Substrat auf ein positives Potential gebracht wird und das Material auf das Masse-Potential oder ein negatives Potential gebracht wird.

13. Vorrichtung nach einem der Ansprüche 10 bis 12, dadurch gekennzeichnet, daß auf dem Substrat (8a,8b), das ein Dielektrikum ist, eine Elektrode (26,64) auf der zweiten Oberfläche des Substrats (6a,6b) vorgesehen ist, die mit einer Öffnung (26) versehen ist, die den Durchgang des Laserstrahlbündels (4) durch die Elektrode hindurch erlaubt.

14. Vorrichtung nach einem der Ansprüche 10 bis 13, dadurch gekennzeichnet, daß ein optisches System (48,50) vorgesehen ist zur Aufteilung des Laserstrahlbündels in zwei Abschnitte, wobei ein erster peripherer Abschnitt (7) dazu dient, das Substrat vorzuerwärmen, und ein zweiter zentraler Abschnitt (5) dazu dient, das Dotierungsmittel zu verdampfen, wobei der Dotierungsmittel-Film nur einen Teil der ersten Oberfläche des Substrats bedeckt.

15. Vorrichtung nach Anspruch 14, dadurch gekennzeichnet, daß das optische System zwei ringförmige sphärische Spiegel umfaßt, einen inneren Spiegel (50) und einen äußeren Spiegel (48), die koaxial auf dem von der Quelle (2) gebildeten Laserstrahlbündel (4) so angeordnet sind, daß die konkave Oberfläche (52,54) der beiden Spiegel auf das Material ausgerichtet ist, die reflektierende Oberfläche (56) des inneren Spiegels (4) auf die Quelle (2) hin ausgerichtet ist und die reflektierende Oberfläche (52) des äußeren Spiegels (48) auf das Material hin ausgerichtet ist.

16. Vorrichtung nach einem der Ansprüche 10 bis 15 zur Behandlung eines Materials, das mindestens zum Teil die Innenwand (58) eines hohlen Teils (14b) bildet, dadurch gekennzeichnet, daß sie umfaßt eine Manschette (8b), deren äußere Oberfläche (10b) von einem Dotierungsmittel-Film (12b) bedeckt ist, wobei diese das Substrat bildende Manschette (8b) im Innern des zu behandelnden Stückes angeordnet sein kann, einen Reflektor (68), der in der Manschette angeordnet ist, um das Laserstrahlbündel (4) auf die innere Oberfläche (6b) der Manschette (8b) zu reflektieren, Einrichtungen (62,68,66) zur Erzeugung einer Relativbewegung zwischen dem reflektierten Laserstrahlbündel (4) und der inneren Oberfläche (6b) der Manschette, um die gesamte innere Oberfläche zu bestrahlen.

17. Vorrichtung nach Anspruch 16, dadurch gekennzeichnet, daß die Einrichtungen zur Erzeugung einer Relativbewegung umfassen ein elektrisch leitendes hohles Teil (62), das in der Nähe eines seiner Enden (66) eine Schulter (64) aufweist, die in der Manschette angeordnet ist, wobei dieses Ende (66) auf der inneren Oberfläche (6b) der die Rolle der Elektrode spielenden Manschette aufliegt, der mit dem elektrisch leitenden Element (62) verbundene Reflektor (68) in der Schulter (64) angeordnet ist und das elektrisch leitende Element sich um eine Längsachse (60) drehen und sich parallel zu dieser Achse verschieben kann.

# FIG. 1

# FIG. 3

FIG. 2

# FIG. 4